# EUROPEAN PATENT APPLICATION

(11) **EP 3 800 970 A2**
(43) Date of publication of application: **07.04.2021**
(21) Application number: 20197808.7
(22) Date of filing: 23.09.2020
(51) Int. Cl.: H05K 1/03, H05K 3/46

(54) **A FLEXIBLE PRINTED CIRCUIT BOARD (FPCB) USING A PCT FILM AS AN INSULATING LAYER, AND ITS MANUFACTURING METHOD THEREOF**

(30) Priority: 24.09.2019 KR 20190117768
(71) Applicant: Jin Young Global Co., Ltd., Gyeongsangbuk-do (KR)
(72) Inventor: KIM, Kyong Do, Gyeongsangbuk-do (KR); KIM, Dong Sik, Gyeongsangbuk-do (KR)
(74) Representative: dompatent von Kreisler Selting Werner - Partnerschaft von Patent- und Rechtsanwälten mbB

(57) **Abstract**

In a first embodiment of the present invention, the present invention provides a flexible printed circuit board (FPCB) comprising a hot melt adhesive layer and a metal foil layer sequentially stacked on an insulating layer made of a PCT film; a flexible copper clad laminate (FCCL) having a circuit pattern on the metal foil layer; a coverlay adhered to the hot melt adhesive layer formed on the insulating layer made of the PCT film while covering the metal foil layer and also provides a method of manufacturing the FPCB.

In addition, the second embodiment of the present invention provides an FPCB having a pressure-sensitive adhesive layer instead of the hot-melt adhesive layer, and a method for manufacturing the FPCB having the same, and the third embodiment of the present invention provides an FPCB having a UV cured layer instead of a hot melt adhesive layer, and a method for manufacturing the FPCB having the same.

## Description

### [Technical Field]

The present invention relates to a flexible printed circuit board (hereinafter, abbreviated as "FPCB"), and more particularly, it relates to an FPCB utilizing a film made of polycyclohexylene dimethylene terephthalate (hereinafter, abbreviated as "PCT") as an insulating layer of a coverlay and/or an insulating layer of a flexible copper clad laminate (FCCL).

In addition, the present invention relates to a method of manufacturing the flexible printed circuit board.

### [Background of the Invention]

A flexible printed circuit board (FPCB) refers to a printed circuit board in which a complex electric circuit is formed on a flexible insulating film. Because it has a characteristic of bending unlike a rigid printed circuit board, it already has been used in a various industry (an automobile, a medical device, a semiconductor equipment, a computer, a lighting device, etc.), and is expected to be used in more industrial fields in the future.

A method for manufacturing such an FPCB is disclosed in Registration Patent No. 10-1606492 (Method of Manufacturing a Flexible Circuit Board), in which a flexible film layer and a coverlay are prepared at first.

In the process of preparing the flexible film layer, a copper foil is formed on an insulating film made of a polyester resin through a hot melt adhesive. One of a PET (polyethylene terephthalate) resin, a PTT (polytrimethylene terephthalate) resin, a PBT (polybutylene terephthalate) resin, a PCT (polycyclohexylene dimethylene terephthalate) resin, and a PEN (polyethylene naphthalate) resin is used as the polyester resin. When the PET resin is used, the thickness of the insulating film is set to be 1 ∼ 12 µm, and the thickness of the hot melt adhesive is set to be 1 ∼ 10 µm.

In the process of preparing the coverlay, a hot melt adhesive is adhered to the lower surface of the PET film. The thickness of the PET film is set to be 1 to 7 µm, and the thickness of the hot melt adhesive is set to be 1 to 8 µm.

When the flexible film layer and the coverlay are prepared, a bonding process is performed. In the bonding process, the hot-melt adhesive of the flexible film layer and the hot-melt adhesive of the coverlay are in contact with each other by applying weak heat to temporarily bond them, followed by hot pressing to completely bond them together.

### [Prior Technical Literature]

### [Patent Literature]

Registered Patent No. 10-1606492 (Flexible circuit board manufacturing method)

### [Summary of Invention]

### [Problem to be Solved]

Since a PCT resin has superior properties (heat resistance, dimensional stability, chemical resistance, weather resistance, moisture resistance, insulation, etc.) over a PET resin, it is more advantageous to use the PCT film as an insulating layer of FPCB (means the insulating layer of the coverlay or the insulating layer of the FCCL) over a PET film.

Nevertheless, the reason that the PCT film was not used as an insulating layer for the FPCB was because the PCT resin could not be processed into a film form due to the fast hardening property of the PCT resin. Recently (around the end of year 2018), SKC succeeded in mass production of the for the first time worldwide thereby it is possible to utilize the PCT film as an insulating layer for the FPCB.

Since Patent No. 10-1606492 above discloses that the insulating layer of the flexible copper clad laminate (described as the flexible film layer) may have a PCT film, it may be thought that it can also be used in the manufacture of FPCB having the insulating layer made of the PCT film through the hot press method as disclosed in the above registered patent. However, the hot press method disclosed in the above registered patent is an example only when the insulating layer of the FCCL is a PET film, and furthermore, the insulating layer of the coverlay is also a PET film. Therefore, the PCT film cannot be applied to the manufacture of an FPCB as an insulating layer and/or an insulating layer of a coverlay according to the method disclosed in the above patent.

Accordingly, the present invention is to provide a method for manufacturing a flexible printed circuit board (FPCB) using a PCT film as an insulating layer of a flexible copper clad laminate and/or an insulating layer of a coverlay, and the flexible printed circuit board by a hot press method and other methods.

### [Means to Solve Problems]

In a first embodiment of the present invention, the present invention provides an FPCB having an insulating layer made of a PCT film comprising a hot-melt adhesive layer and a metal foil layer sequentially laminated on an insulating layer made of a PCT film, and a flexible copper clad laminate having a circuit pattern on the metal foil layer; and a coverlay combining to the hot melt adhesive layer formed on the insulating layer made of the PCT film while covering a metal foil layer. It is appropriate for FPCB to have its thickness of the insulating layer of the FCCL and the insulating layer of the coverlay being in the range of 45 µm to 55 µm, and the thickness of the metal foil layer being in the range of 30 µm to 40 µm.

The PCT film used as the insulating layer of the FCCL and the insulating layer of the coverlay may be an ultraviolet pre-treated PCT film pretreated by irradiation with ultraviolet ray. Here, the ultraviolet ray may have a wavelength in the range of 170 nm to 180 nm.

The manufacturing method for manufacturing an FPCB using a PCT film as an insulating layer according to the first embodiment includes a hot-pressing process to adhere an FCCL where it is formed by sequentially stacking a hot melt adhesive layer and a metal foil layer on which a circuit pattern is formed on an insulating layer made of the PCT film, and a coverlay where the hot melt adhesive layer is formed on the insulating layer made of the PCT film by hot pressing. In the hot-pressing process, heat of a temperature within the range of 150 °C to 155 °C and a pressure within the range of 33 kgf/in² to 39 kgf/in² are applied to the FCCL where the hot melt layers are overlappingly abut each other and the coverlay for within the range of 60 minutes to 90 minutes.

It is appropriate that the insulating layer of the FCCL and the insulating layer of the coverlay may respectively have a thickness in the range of 45 µm to 55 µm, and the metal foil layer may ha a thickness in the range of 30 µm to 40 µm.

The PCT film used as the insulating layer of the FCCL and the insulating layer of the coverlay may be a UV pretreated PCT film pretreated by irradiating ultraviolet ray before the hot melt adhesive layer is formed. The ultraviolet ray may have a wavelength in the range of 170 nm to 180 nm.

A second embodiment of the present invention relates a pressure-sensitive adhesive layer and a metal foil layer sequentially stacked on an insulating layer made of a PCT film, and it provides an FPCB using the PCT film as the insulating layer to include an FCCL having a circuit pattern on the metal foil layer; and a coverlay formed to have the pressure-sensitive adhesive layer wherein the coverlay covers the metal foil layer on the insulating layer made of the PCT film and combines with the pressure-sensitive adhesive layer.

It is appropriate that the insulating layer of the FCCL and the insulating layer of the coverlay may respectively have a thickness within the range of 45 µm to 55 µm, the metal foil layer may have a thickness within the range of 30 µm to 40 µm, and the pressure-sensitive adhesive layer may have a thickness in the range of 20 µm to 45 µm.

The PCT film used as the insulating layer of the FCCL and the insulating layer of the coverlay may be a UV pretreated PCT film pretreated by irradiation with ultraviolet ray. The ultraviolet ray may have a wavelength in the range of 170 nm to 180 nm.

The manufacturing method for manufacturing an FPCB using a PCT film as an insulating layer according to the second embodiment includes a lamination process to laminate a FCCL where a pressure-sensitive adhesive layer and a metal foil layer where a circuit pattern is formed are sequentially stacked on the insulating layer made of the PCT film and a coverlay where the pressure-sensitive adhesive layer is formed on the insulating layer made of the PCT film. In the lamination process, the FCCL where the pressure-sensitive adhesive layers are overlapping abut each other and the coverlay are pressed at a pressure within the range of 1 kgf/in² to 3 kgf/in² while passing between a pair of pressing rollers at room temperature.

The PCT film used as the insulating layer of the FCCL and the insulating layer of the coverlay may be a UV pretreated PCT film pretreated by irradiating ultraviolet ray before the pressure-sensitive adhesive layer is formed. The ultraviolet ray may have a wavelength in the range of 170 nm to 180 nm.

In a third embodiment of the present invention, a UV cured layer and a metal foil layer sequentially stacked on an insulating layer made of a PCT film, and it provides an FPCB using the PCT film as the insulating layer to include an FCCL having a circuit pattern on the metal foil layer; and a coverlay formed to have the UV cured layer wherein the coverlay covers the metal foil layer on the insulating layer made of the PCT film and combines with the UV cured layer.

It is appropriate that the insulating layer of the FCCL and the insulating layer of the coverlay may respectively have a thickness within the range of 45 µm to 55 µm, the metal foil layer may have a thickness within the range of 30 µm to 50 µm, and the UV cured layer may have a thickness in the range of 10 µm to 40 µm.

The PCT film used as the insulating layer of the FCCL and the insulating layer of the coverlay may be a UV pretreated PCT film pretreated by irradiation with ultraviolet ray. The ultraviolet ray may have a wavelength in the range of 170 nm to 180 nm.

The UV cured layer of the FCCL and the UV cured layer of the coverlay are provided to be cured by ultraviolet ray having a wavelength greater than that of the ultraviolet ray used in the pretreatment. Specifically, the UV cured layer of the FCCL and the UV cured layer of the coverlay are provided to be cured by the ultraviolet ray having a wavelength in the range of 340 nm to 360 nm.

The manufacturing method for manufacturing FPCB using a PCT film as an insulating layer according to the second embodiment includes a UV curing process to combine a FCCL where a UV cured layer and a metal foil layer where a circuit pattern is formed are sequentially stacked on the insulating layer made of the PCT film and a coverlay where the UV cured layer is formed on the insulating layer made of the PCT film. In the UV curing process, the FCCL where the UV cured layers are overlappingly abut with each other and the coverlay are passing through an area where the UV ray having a wavelength in the range of 340 nm to 360 nm is irradiated.

It is appropriate that the insulating layer of the FCCL and the insulating layer of the coverlay may respectively have a thickness within the range of 45 µm to 55 µm, the metal foil layer may have a thickness within the range of 30 µm to 50 µm, and the UV cured layer may have a thickness in the range of 10 µm to 40 µm.

The PCT film used as the insulating layer of the FCCL and the insulating layer of the coverlay may be a UV pretreated PCT film pretreated by irradiation with ultraviolet ray. The ultraviolet ray may have a wavelength in the range of 170 nm to 180 nm.

### [Effects of Invention]

According to the present invention, a PCT film having excellent physical properties and cheaper price compared to the PI film generally used as an insulating layer of an FCCL and a coverlay, is effectively used to make the insulating layer of the FCCL and the coverlay of the FPCB while obtaining a sufficient adhesion and bonding strength among the layers. Furthermore, in the second and third embodiments of the present invention, since the FPCB can be manufactured in a roll-to-roll method, thus the productivity can be improved, and thermal damage to the FCCL and the coverlay can be effectively prevented.

In addition, according to the present invention, since the UV-treated PCT film is used as the insulation layer of the FCCL and the coverlay, compared to the case where the PCT film before UV pre-treatment is used as the above insulation layer, the physical properties of the upper insulation layer (dimension stability, adhesion strength) and more excellent effect occurs.

### [Explanation of Drawings]

FIG. 1 is a cross-sectional view of an FPCB using a PCT film as an insulating layer according to a first embodiment of the present invention.
FIG. 2 is for explaining a method of manufacturing the FPCB shown in FIG. 1.
FIG. 3 is a modified example of the FPCB shown in FIG. 1.
FIG. 4 is for explaining a method of manufacturing the FPCB shown in FIG. 3.
FIG. 5 is a cross-sectional view of an FPCB using a PCT film as an insulating layer according to a second embodiment of the present invention.
FIG. 6 is for explaining a method of manufacturing the FPCB shown in FIG. 5.
FIG. 7 is a modified example of the FPCB shown in FIG. 5.
FIG. 8 is for explaining a method of manufacturing the FPCB shown in FIG. 7.
FIG. 9 is a cross-sectional view of an FPCB using a PCT film as an insulating layer according to a third embodiment of the present invention.
FIG. 10 is for explaining a method of manufacturing the FPCB shown in FIG. 9.
FIG. 11 is a modified example of the FPCB shown in FIG. 9.
FIG. 12 is for explaining a method of manufacturing the FPCB shown in FIG. 11.

### [Description of Preferred Embodiments]

Here, preferred embodiments of a FPCB using a PCT film as an insulating layer according to the present invention and a method of manufacturing the same will be described in detail with reference to the drawings. The terms or words used below should not be interpreted as being limited to their usual or dictionary meanings, and based on the principle that the inventor can appropriately define the concept of terms in order to describe his own invention in the best way. It should be interpreted as a meaning and concept consistent with the technical idea of the present invention.

Here, although various embodiments of the present invention will be described, but it will be stated the flexible printed circuit board is abbreviated as FPCB, and the polycyclohexylene dimethylene terephthalate is abbreviated as PCT.

### <First Embodiment>

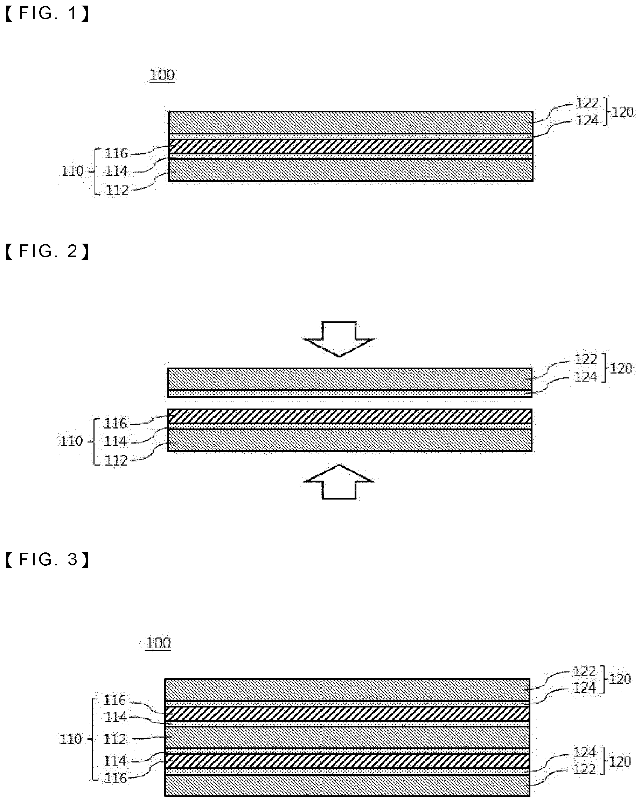

An FPCB (100) using a PCT film as an insulating layer according to the first embodiment of the present invention includes a flexible copper clad laminate (FCCL) (110) and a coverlay (120) as shown in FIG. 1.

The FCCL (110) has a structure where a hot-melt adhesive layer (acrylic-based, epoxy-based, etc.) (114) and a metal foil layer (copper foil, etc.) (116) are sequentially stacked on an insulating layer (112) made of a PCT film. In addition, a circuit pattern is formed on the metal foil layer (116). The circuit pattern may be formed by sequentially applying a photosensitive layer formation, exposure, development, etching, and peeling process to the metal foil layer (116) as disclosed in Patent No. 10-1606492 introduced in the prior art.

The coverlay (120) has a structure where a hot-melt adhesive layer (acrylic-based, epoxy-based, etc.) (124) is formed on an insulating layer (122) made of a PCT film. The coverlay (120) is combined with the FCCL (110) in a form where the hot melt adhesive layer (124) is adhered to the hot melt adhesive layer (114) of the FCCL (110). At this time, the metal foil layer (116) is covered by the hot melt adhesive layer (124) of the coverlay (120).

A thickness of the insulating layer (PCT film) (112) of the FCCL (110) may be formed within the range of 45 µm to 55 µm, and a thickness of the insulating layer (PCT film) (122) of the coverlay (120) may suitably be formed within the range of 45 µm to 55 µm. And, it is appropriate that a thickness of the metal foil layer (116) of the FCCL (110) may be formed within the range of 30 µm to 40 µm.

The PCT film (112) used as the insulating layer (112) of the FCCL (110), and the insulating layer (122) of the coverlay (120) may preferably be configured to use a pre-treated PCT film going through a UV pretreatment process.

In the UV pretreatment process, the UV is only irradiated to the PCT film (112) used as the insulating layer (112) of the FCCL (110) before the hot melt adhesive layer (114) and the metal foil layer (116) of the FCCL (110) are stacked and is also only irradiated to the PCT film (122) used as the insulating layer (122) of the coverlay (120) before the hot melt adhesive layer (124) of the coverlay (110) is formed. In this case, the irradiating UV is used to have a wavelength in the range of 170 nm to 180 nm.

Since the PCT film without the UV pretreatment has lower dimensional stability and heat resistance at high temperature than the PI film mainly used as the insulating layers (112 and 122), there is a concern that dimensional deformation such as distortion or shrinkage may occur in the PCT film without the UV pretreatment in a process of forming the circuit pattern on the metal foil layer (116) of the FCCL (110) and in a process of adhering the FCCL (110) and the coverlay (120) by hot-pressing. However, the UV pre-treated PCT film has better dimensional stability than the PCT film without the UV pre-treatment. Therefore, when the UV pre-treated PCT film is used as the insulating layers (112, 114) of the FCCL (110) and the coverlay (120), the effect of securing excellent dimensional stability of the insulating layers (112, 114) is possible.

In addition, since the PCT film without the UV pretreatment has excellent chemical resistance and moisture resistance, it is not easy to secure the adhesive strength between the insulating layers (112, 122) made of the PCT film without the UV pretreatment and the hot melt adhesive layers (114, 124). However, since the UV-treated PCT film exhibits better adhesion property than the PCT film without the UV pre-treatment, it is possible to obtain much stronger adhesive strength between the insulating layers (112, 122) and the adhesive layers (114, 124) if the UV-treated PCT film is used as the insulation layers (112, 122).

To manufacture the FPCB (100) described above, at first, the FCCL (110) and the coverlay (120) shall be prepared.

In the process of preparing the FCCL (110), the UV pre-treated PCT film is used as an insulating layer (112) after irradiating the UV ray having a wavelength in the range of 170 nm to 180 nm to the PCT film that has not been pre-treated with the UV ray to make an ultraviolet pre-treated PCT film. In this case, a PCT film that has not been pre-treated with the UV may be used as the insulating layer (112). Then, the hot melt adhesive layer (114) and the metal foil layer (116) are stacked on the insulating layer (112) to make the FCCL (110), and the circuit pattern is formed by sequentially applying the processes of forming a photosensitive layer on the metal foil layer (116), exposing, developing, etching, and peeling off the photosensitive layer.

For the FCCL (110) formed as above, the thickness of the insulating layer (PCT film) (112) may be preferably formed within the range of 45 µm to 55 µm, and the thickness of the metal foil layer (116) may be preferably formed within the range of 30 µm to 40 µm.

For the process of preparing the coverlay (120), either the UV pre-treated PCT film or the PCT film without the UV pretreatment is used as the insulating layer (122), and then the hot melt adhesive layer (124) is formed on the insulating layer (122 thereby the coverlay (120) is made. For the coverlay (120), it is appropriate that the thickness of the insulating layer 122 is formed within the range of 45 µm to 55 µm.

The FCCL (110) and the coverlay (120) prepared as described above are bonded to each other through a hot-pressing process. As shown in FIG. 2, in the hot-pressing process, the FCCL (110) where the two hot melt adhesive layers (114, 124) are overlappingly abut each other and the coverlay (120) are pressed and heated by a pair of heating plates (not shown). At this time, heat of a temperature within the range of 150 °C to 155 °C and a pressure within the range of 33 kgf/in² to 39 kgf/in² are applied to the FCCL (110) and the coverlay (120) for within the range of 60 minutes to 90 minutes. When the hot-pressing process is finished, the hot melt adhesive layer (124) of the coverlay (120) adheres to the hot melt adhesive layer (114) of the FCCL (110) while covering the metal foil layer (116) of the FCCL (110).

Due to the development of related technologies, micronizing of a circuit pattern is on the rise. In addition, when the micronized circuit pattern is formed on the metal foil layer (114), the circuit may be short-circuited if too much pressure is applied in the hot-pressing process. Therefore, in the hot-pressing process, relatively low pressure is applied as stated above.

However, the excellent chemical resistance and moisture resistance of the PCT film acts as a disadvantage in securing sufficient adhesive strength between the insulating layers (112, 122) made of the PCT film and the hot melt adhesive layers (114, 124) from the viewpoint of manufacturing. Therefore, a hot-pressing process is performed for a relatively long time at a relatively high temperature as stated above to sufficiently secure adhesive strength between the insulating layers (112, 122) and the hot melt adhesive layers (114, 124). In addition, as described above, when the UV pre-treated PCT film is used as the insulating layers (112, 122), it is possible to secure better adhesive strength compared to the case of using the PCT film without the UV pre-treatment as the insulating layers (112, 122).

Meanwhile, FIG. 1 shows an FCCL 110 where a hot melt adhesive layer (114) and a metal foil layer (116) are stacked on only one surface of the insulating layer (112), but as shown in FIG. 3, an FCCL (110) may be in a form where a hot melt adhesive layer (114) and a metal foil layer (116) are stacked on both sides of the insulating layer (112). And in this case, a pair of coverlays (120) are adhered to both sides of the FCCL (110).

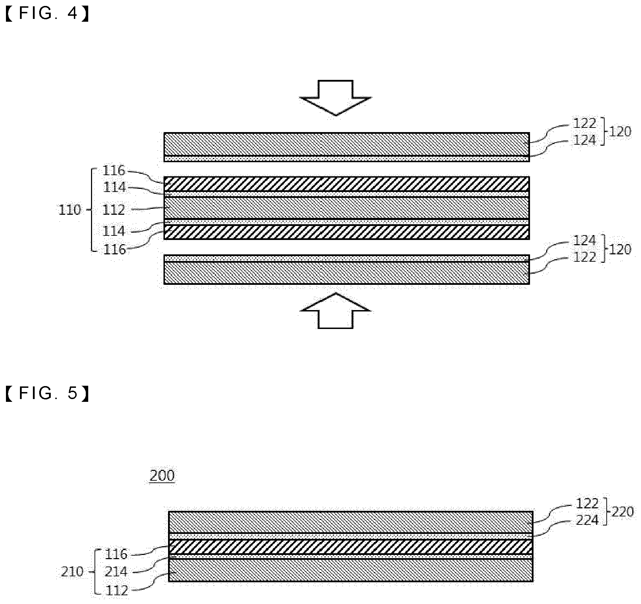

In the case of manufacturing the FPCB (100) of the type shown in FIG. 3, as shown in FIG. 4, a pair of coverlays (120) are overlapped on both sides of the FCCL (110), respectively, and then, the hot-pressing process is performed under the same conditions as stated above.

### <Second Embodiment>

Here, a second embodiment of the present invention will be described with reference to FIGs. 5 to 8, but differences from the first embodiment will be mainly described. Numerals in the drawing for the same members as in the first embodiment are also referred to in FIGs. 5 to 8 as same.

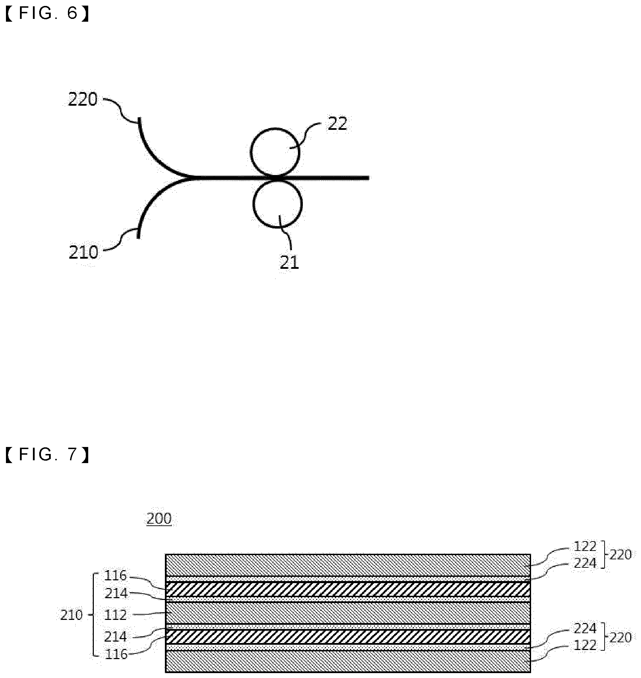

As shown in FIGs. 5 and 7, in the FPCB (200) according to the present embodiment, a pressure-sensitive adhesive layer (silicon-based or acrylite-based) (214) is stacked on the FCCL (210) rather than a hot melt adhesive (114) in the first embodiment and a pressure-sensitive adhesive layer (silicon-based or acrylite-based) (224) is also formed on the coverlay (220) instead of the hot melt adhesive layer (124) in the first embodiment.

In addition, in this embodiment, the thickness of the insulating layer (112) of the FCCL (210) is formed within the range of 45 µm to 55 µm, and it is suitable that the thickness of the insulating layer (122) of the coverlay (220) is also formed within the range of 45 µm to 55 µm. In addition, it is appropriate that the thickness of the metal foil layer (116) of the FCCL (210) may be formed within the range of 30 µm to 40 µm, and the thickness of the pressure-sensitive adhesive layers (214, 224) may be formed within the range of 20 µm to 45 µm.

To manufacture the FPCB (200) of this embodiment, as stated in the first embodiment, the FCCL (210) and the coverlay (220) are prepared, but the pressure-sensitive adhesive layer (214) is stacked on the insulating layer (112) of the FCCL (210) and a pressure-sensitive adhesive layer (224) is also formed on the insulating layer (122) of the coverlay (220) unlike the first embodiment.

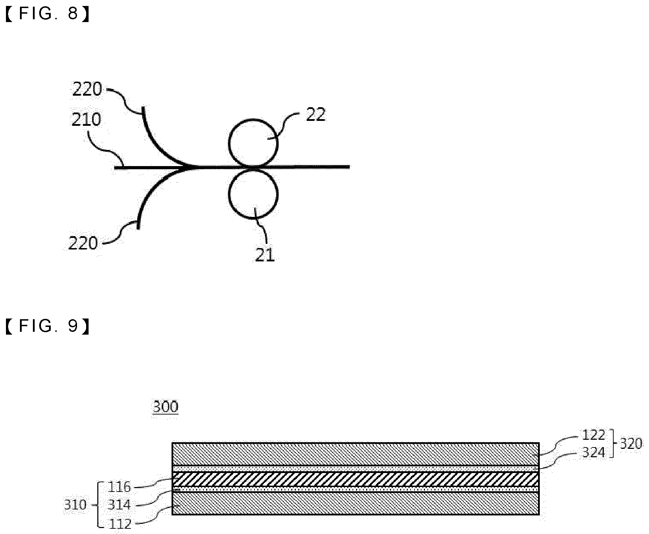

In addition, in this embodiment, the FCCL (210) and the coverlay 220 are combined each other through a lamination process instead of the hot-pressing process of the first embodiment. As shown in FIGs. 6 and 8, in the lamination process, the FCCL (210) where the pressure-sensitive adhesive layers (214, 224) are overlapping abut each other and the coverlay (220) are pressed at a pressure within the range of 1 kgf/in² to 3 kgf/in² while passing between a pair of pressing rollers (21, 22) at room temperature. The FCCL (210) and the coverlay (220) passing a pair of pressing rollers (21, 22) are left at room temperature. When this lamination process is completed, the pressure-sensitive adhesive layer (224) of the coverlay (220) is bonded to the pressure-sensitive adhesive layer (214) of the FCCL (210) while covering the metal foil layer (116) of the FCCL (210).

In the lamination process, the pressure-sensitive adhesive layer (214) of the FCCL (210) and the pressure-sensitive adhesive layer (224) of the coverlay (220) are combined with a predetermined adhesive strength due to their pressure-sensitive adhesiveness while passing between the pair of pressure rollers (21, 22), and the bonding strength between the pressure-sensitive adhesive layers (214, 224) is further increased while they are left at room temperature later.

Since the lamination process in this embodiment can be continuously performed in a roll-to-roll method, it has superior productivity compared to the hot-pressing process. In addition, since heat is not applied to the FCCL (210) and the coverlay 220 in the lamination process, thermal damage to the two members (210, 220) can be prevented.

### <Third Embodiment>

Here, a third embodiment of the present invention will be described with reference to FIGs. 9 to 12, but differences from the first embodiment will be mainly described. Numerals in the drawing for the same members as in the first embodiment are also referred to in FIGs. 9 to 12 as same.

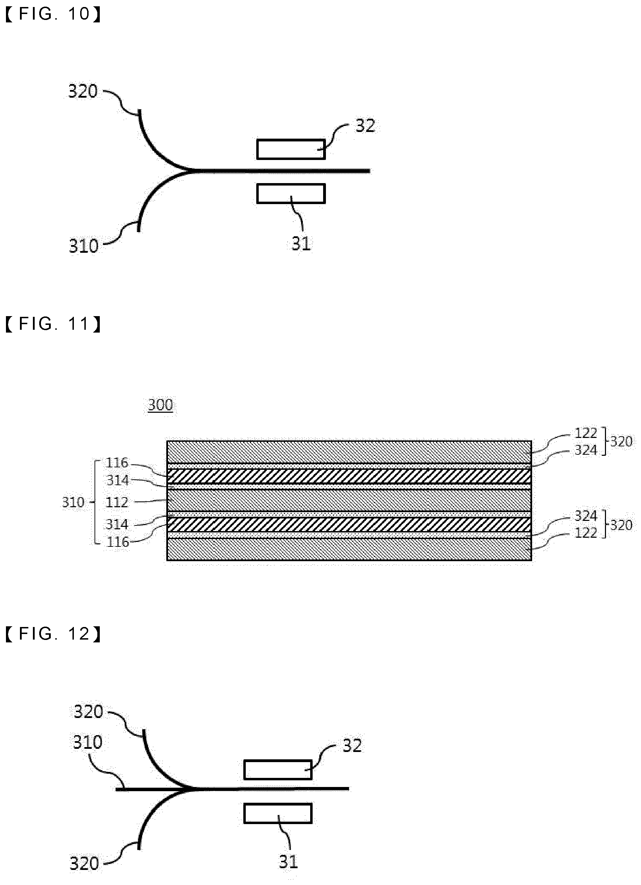

As shown in FIGs. 9 and 11, in the FPCB (300) according to the present embodiment, a UV cured layer (314) on the FCCL (310) is laminated instead of the hot melt adhesive layer (114) in the first embodiment. In addition, a UV cured layer (324) is formed on the coverlay (320) instead of the hot melt adhesive layer (124) in the first embodiment.

In addition, in this embodiment, a thickness of the insulating layer (312) of the FCCL (310) may preferable be formed within the range of 45 µm to 55 µm, and a thickness of the insulating layer (322) of the coverlay (320) may also be formed within the range of 45 µm to 55 µm. And, it is appropriate that a thickness of the metal foil layer (116) of the FCCL (310) may be formed within the range of 30 µm to 50 µm, and a thickness of the UV cured layers (314, 324) may be formed within the range of 10 µm to 40 µm.

As in the first embodiment, in this embodiment, the UV pre-treated PCT film pre-treated with the UV having a wavelength in the range of 170 nm to 180 nm may be used as the insulating layer (112) of the FCCL (310) and the insulating layer (112) of the coverlay (320). The UV cured layer (314) of the FCCL (310) and the UV cured layer (324) of the coverlay (320) are provided to be cured by UV ray having a wavelength greater than that of the UV ray used in the pretreatment. Specifically, the UV cured layers (314, 324) are provided to be cured by the UV ray having a wavelength in the range of 340 nm to 360 nm.

Ultraviolet curing resin refers to a resin cured by UV irradiation, and generally includes an oligomer, a monomer, and a photoinitiator. A photoinitiator is material that initiates a polymerization reaction by receiving UV ray. When the photoinitiator initiates a polymerization reaction, the oligomer and the monomer undergo a polymerization reaction to change into a polymer having a very large molecular weight, which is called UV curing.

The UV- curable resin can be used for various purposes depending on the type of oligomer, monomer, and photoinitiator. In the present invention, the UV cured layers (314, 324) are cured by UV ray having a wavelength in the range of 340 nm to 360 nm through appropriate selection of photoinitiators.

To manufacture the FPCB (300) of this embodiment, as in the first embodiment, a FCCL (310) and a coverlay (320) are prepared, but a UV cured layer is stacked on the insulating layer (112) of the FCCL (310) and the UV cured layer (324) is also formed on the insulating layer (122) of the coverlay (320) unlike the first embodiment.

In addition, in this embodiment, the FCCL (310) and the coverlay (320) are combined with each other through a UV curing process instead of the hot-pressing process of the first embodiment. As shown in FIGs. 10 and 12, in the UV curing process, the FCCL (310) where the UV cured layers (314, 324) are overlappingly abut with each other and the coverlay (320) are exposed to UV ray irradiated from a lamp (31, 32) having a wavelength in the range of 340 nm to 360 nm while passing through the UV lamp (31, 32). When the UV curing process is completed, the UV cured layer (324) of the coverlay (320) is combined to the UV cured layer (314) of the FCCL (310) while covering the metal foil layer (116) of the FCCL (310).

Since the UV curing process in this embodiment can be continuously performed in a roll-to-roll method as in the second embodiment, it has better productivity than the hot-pressing process. In addition, since heat is hardly applied to the FCCL (310) and the coverlay (320) in the UV curing process, thermal damage to the two members (310, 320) can be prevented.

As described above, although the present invention has been described by limited embodiments and drawings, the present invention is not limited, and the scope of the present invention can be freely and variously changed and modified within the equivalent scope of the technical and following claims to be described by those of ordinary skill in the art to which the present invention pertains. The above-described embodiments may be variously combined as well.

### [Description of Numbers]

100, 200, 300: Flexible Printed Circuit Board (FPCB)
110, 210, 310: flexible copper clad laminate (FCCL)
120, 220, 320: coverlay
112, 122: insulating layer (PCT film)
114, 124: hot melt adhesive layer
116: metal foil layer
214, 224: pressure-sensitive adhesive layer
314, 324: UV cured layer
21, 22: pressure roller
31, 32: ultraviolet lamp

## Claims

1. A FPCB comprising:
a hot melt adhesive layer and a metal foil sequentially stacked on an insulating layer made of a PCT film;
a FCCL having a circuit pattern on the metal foil layer; and
a coverlay combining to the hot melt adhesive layer formed on the insulating layer made of the PCT film while covering the metal foil layer
wherein a thickness of the insulating layer of the FCCL and the insulating layer of the coverlay is within a range of 45 µm to 55 µm, respectively, and a thickness of the metal foil layer is within a range of 30 µm to 40 µm.

2. The FPCB of claim 1 wherein the PCT film used as the insulating layer of the FCCL and the coverlay is a UV pre-treated PCT film where the PCT film is pre-treated by irradiating a UV ray.

3. The FPCB of claim 2 wherein the UV pre-treated PCT film is pre-treated by irradiating the UV ray having a wavelength in a range of 170 nm to 180 nm.

4. A method of manufacturing a FPCB having an insulating layer made of a PCT film comprising the steps of:
performing a hot-pressing process to bond a FCCL where a hot melt adhesive layer and a circuit pattern are sequentially stacked and a coverlay where the hot melt adhesive layer is formed on the insulating layer made of the PCT film together
wherein the FCCL where the hot melt adhesive layer is overlappingly abut and the coverlay are heated and pressed under a temperature within a range of 150 °C to 155 °C and under a pressure within a range of 33 kgf/in² to 39 kgf/in² for a time within a range of 60 to 90 minutes in the hot-pressing process.

5. The method of claim 4 further comprising the steps of:
forming the insulating layer of the FCCL and the insulating layer of the coverlay to have a thickness within a range of 45 µm to 55 µm, respectively; and
forming the metal foil layer to have a thickness within a range of 30 µm to 40 µm.

6. The method of claim 4 wherein the PCT film used as the insulating layer of the FCCL and the coverlay is a UV pre-treated PCT film where the PCT film is pre-treated by irradiating a UV ray before forming the hot melt adhesive layer.

7. The method of claim 6 wherein the UV pre-treated PCT film is pre-treated by irradiating the UV ray having a wavelength in a range of 170 nm to 180 nm.

8. A FPCB comprising:
a pressure-sensitive adhesive layer and a metal foil sequentially stacked on an insulating layer made of a PCT film;
a FCCL having a circuit pattern on the metal foil layer; and
a coverlay combining to the pressure-sensitive adhesive layer formed on the insulating layer made of the PCT film while covering the metal foil layer.

9. The FPCB of claim 8 wherein a thickness of the insulating layer of the FCCL and the insulating layer of the coverlay is within a range of 30 µm to 40 µm, respectively, and a thickness of the metal foil layer is within a range of 20 µm to 45 µm,

10. The FPCB of claim 8 wherein the PCT film used as the insulating layer of the FCCL and the coverlay is a UV pre-treated PCT film where the PCT film is pre-treated by irradiating a UV ray.

11. The FPCB of claim 10 wherein the UV pre-treated PCT film is pre-treated by irradiating the UV ray having a wavelength in a range of 170 nm to 180 nm.

12. A method of manufacturing a FPCB having an insulating layer made of a PCT film comprising the steps of:
performing a lamination process to laminate a FCCL where a pressure-sensitive adhesive layer and a circuit pattern are sequentially stacked and a coverlay where the pressure-sensitive adhesive layer is formed on the insulating layer made of the PCT film together
wherein the FCCL where the pressure-sensitive adhesive layer is overlappingly abut and the coverlay are pressed under a pressure within a range of 1 kgf/in² to 3 kgf/in² while passing between a pair of pressing rollers at a room temperature in the lamination process.

13. The method of claim 12 wherein the PCT film used as the insulating layer of the FCCL and the coverlay is a UV pre-treated PCT film where the PCT film is pre-treated by irradiating a UV ray before forming the pressure-sensitive adhesive layer.

14. The method of claim 13 wherein the UV pre-treated PCT film is pre-treated by irradiating the UV ray having a wavelength in a range of 170 nm to 180 nm.

15. A FPCB comprising:
a UV cured layer and a metal foil sequentially stacked on an insulating layer made of a PCT film;
a FCCL having a circuit pattern on the metal foil layer; and
a coverlay combining to the UV cured layer formed on the insulating layer made of the PCT film while covering the metal foil layer.

16. The FPCB of claim 15 wherein a thickness of the insulating layer of the FCCL and the insulating layer of the coverlay is within a range of 45 µm to 55 µm, respectively; a thickness of the metal foil layer is within a range of 30 µm to 50 µm; and a thickness of the UV cured layer is within a range of 10 µm to 40 µm.

17. The FPCB of claim 15 wherein the PCT film used as the insulating layer of the FCCL and the coverlay is a UV pre-treated PCT film where the PCT film is pre-treated by irradiating a UV ray before forming the UV cured layer.

18. The FPCB of claim 17 wherein the UV pre-treated PCT film is pre-treated by irradiating the UV ray having a wavelength in a range of 170 nm to 180 nm.

19. The FPCB of claim 17 or 18 wherein the UV cured layer of the FCCL and the UV cured layer of the coverlay are cured by the UV ray having a wavelength greater than the wavelength of the UV ray used for the pretreatment of the PCT film.

20. The FPCB of claim 19 wherein the UV cured layer of the FCCL and the UV cured layer of the coverlay are cured by the UV ray having a wavelength in a range of 340 nm to 360 nm.

21. A method of manufacturing a FPCB having an insulating layer made of a PCT film comprising the steps of:
performing a UV curing process to combine a FCCL where a UV cured layer and a circuit pattern are sequentially stacked and a coverlay where the UV cured layer is formed on the insulating layer made of the PCT film together
wherein the FCCL where the UV cured layer is overlappingly abut and the coverlay are passing an area where the UV ray having a wavelength within a range of 340 nm to 360 nm is irradiated in the UV curing process.

22. The method of claim 21 further comprising the steps of:
forming the insulating layer of the FCCL and the insulating layer of the coverlay to have a thickness within a range of 45 µm to 55 µm, respectively;
forming the metal foil layer to have a thickness within a range of 30 µm to 50 µm; and
forming the UV cured layer to have a thickness within a range of 10 µm to 40 µm.

23. The method of claim 21 wherein the PCT film used as the insulating layer of the FCCL and the coverlay is a UV pre-treated PCT film where the PCT film is pre-treated by irradiating a UV ray before forming the UV cured layer.

24. The method of claim 23 wherein the UV pre-treated PCT film is pre-treated by irradiating the UV ray having a wavelength in a range of 170 nm to 180 nm.
